# EUROPEAN PATENT APPLICATION

(11) **EP 3 413 463 A1**
(43) Date of publication of application: **12.12.2018**
(21) Application number: 17174607.6
(22) Date of filing: 06.06.2017
(51) Int. Cl.: H03G 3/30, H03G 5/16, H03F 1/52, H03G 9/02, H04R 3/04

(54) **ELECTRONIC CIRCUIT AND METHOD OF OPERATION**

(71) Applicant: Vestel Elektronik Sanayi ve Ticaret A.S., 45030 Manisa (TR)
(72) Inventor: ÇUBUKÇU, Baran, 45030 Manisa (TR)
(74) Representative: Flint, Adam

(57) **Abstract**

An electronic circuit (12) has circuitry (16) for separately processing plural frequency bands of an audio signal. A temperature monitor (18) monitors the temperature of the electronic circuit. A controller adjusts the processing of at least one of the plural frequency bands of the audio signal (14) so as to reduce the temperature of the electronic circuit (12) if the temperature of the electronic circuit exceeds a predetermined threshold.

## Description

### Technical Field

The present disclosure relates to an electronic circuit and a method of operating an electronic circuit.

### Background

A known problem with many electronic circuits is that they generate heat in operation, which can be excessive in some cases, potentially leading to damage of the circuit. A typical known solution for a device which has an electronic circuit that is overheating is to simply shut down the device completely.

### Summary

According to a first aspect disclosed herein, there is provided an electronic circuit, the electronic circuit comprising:
circuitry for separately processing plural frequency bands of an audio signal;
a temperature monitor for monitoring the temperature of the electronic circuit; and
a controller arranged to adjust the processing of at least one of the plural frequency bands of the audio signal so as to reduce the temperature of the electronic circuit if the temperature of the electronic circuit exceeds a predetermined threshold.

The audio signal may be in analogue form when processed or may be in the form of digital audio data when processed.

This enables a reduction in temperature to be achieved with minimal disruption for the user. In some cases, the reduction in temperature may be achieved without the user being aware of the change of processing.

In an example, the controller is arranged such that the adjusting comprises adjusting the processing of some but not all of the plural frequency bands of the audio signal so as to reduce the temperature of the electronic circuit.

In an example, the electronic circuit comprises an integrated circuit.

In an example, the electronic circuit comprises plural integrated circuits. Each of the plural integrated circuits may for example process a single respective frequency band.

In an example, each integrated circuit is an amplifier and the processing comprises amplifying the audio plural frequency bands of the audio signal, arranged such that the adjusting the processing of said at least one of the plural frequency bands of the audio signal comprises reducing the gain applied to said at least one of the plural frequency bands of the audio signal. The "amplifier" may be for example a preamplifier or a power amplifier, or a single "integrated" amplifier.

In an example, the electronic circuit is arranged such that if the temperature of the electronic circuit still exceeds a predetermined threshold after the gain applied to said at least one of the plural frequency bands of the audio signal is reduced, then the controller at least one of (i) further reduces the gain applied to said at least one of the plural frequency bands and (ii) reduces the gain applied to at least one other of the plural frequency bands. Accordingly, further steps may be taken if the temperature has not been decreased enough to protect the electronic circuit.

In an example, the electronic circuit comprises plural amplifiers, each amplifier being arranged to amplify a respective frequency band, and the controller is arranged to reduce the gain applied by the amplifiers to the respective plural frequency bands of the audio signal by different amounts. For example, the lower (bass) end and the higher (treble) end of the audio spectrum may have their gain reduced more than the middle portion of the audio spectrum.

According to a second aspect disclosed herein, there is provided a method of operating an electronic circuit, the electronic circuit being configured to process an audio signal in which the audio signal is divided into plural frequency bands and the electronic circuit is configured to process the plural frequency bands separately, the method comprising:
the electronic circuit processing plural frequency bands of an audio signal;
monitoring the temperature of the electronic circuit; and
if the temperature of the electronic circuit exceeds a predefined threshold, adjusting the processing of at least one of the plural frequency bands of the audio signal so as to reduce the temperature of the electronic circuit.

### Brief Description of the Drawings

To assist understanding of the present disclosure and to show how embodiments may be put into effect, reference is made by way of example to the accompanying drawings in which:
- Figure 1: shows schematically a first example of an electronic circuit;
- Figure 2: shows schematically a second example of an electronic circuit;
- Figure 3: shows schematically an example of a method; and
- Figure 4: shows schematically an example of another method.

### Detailed Description

As mentioned, a known problem with many electronic circuits is that they generate heat in operation, which can be excessive in some cases, potentially leading to damage of the circuit. A typical known solution for a device which has an electronic circuit that is overheating is to simply shut down the device completely. However, this is not always appropriate or convenient.

As a particular example in the field of consumer devices, an electronic circuit may process an audio signal. The processing may be or include amplifying the audio signal before it is passed to one or more speakers for playback to a user. In some such known consumer devices, such as televisions, radios, audio amplifiers (for music or "hi fi" systems or home cinema systems) and the like, if overheating of the circuit is detected, the device as a whole or at least the audio amplifier part as a whole may be shut down, or the sound volume as a whole may be reduced. Either way, this is inconvenient and disconcerting for a user. The user may for example assume that the device has malfunctioned.

In accordance with some examples described herein, an electronic circuit is provided which processes plural frequency bands of an audio signal. If the temperature of the electronic circuit, which in an example is being checked continuously by a temperature monitor exceeds a predetermined threshold, which is predefined according to the system, the processing of at least one of the plural frequency bands of the audio signal is adjusted so as to reduce the temperature of the electronic circuit. This may be carried out by for example decreasing the gain of at least one of the plural frequency bands of the audio signal. In some examples, processing of some but not all of the plural frequency bands of the audio signal is adjusted so as to reduce the temperature of the electronic circuit. The adjustment may be controlled such as to be practically or barely imperceptible to a user. Once the temperature has dropped sufficiently, normal processing of the audio signal may be resumed. This may be by for example increasing the gains to their original level for the frequency bands that had their gains reduced. Both the decreasing of the gain in a detected emergency situation and the increasing of the gain again when emergency situation ends may be carried out in a stepwise manner so as to not to be noticeable to the end user.

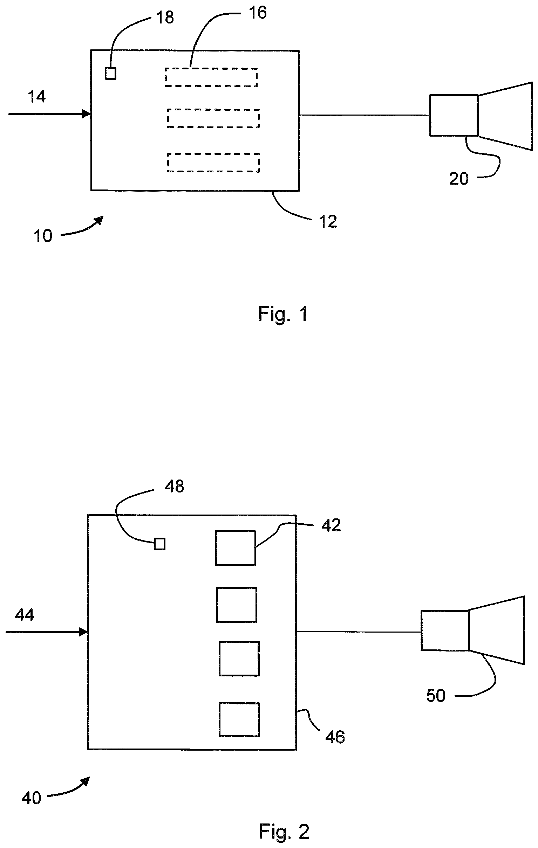

Referring to Figure 1, an example of an electronic circuit 10 for processing an audio signal has a single integrated circuit 12. The integrated circuit 12 is arranged to process plural frequency bands of an incoming audio signal 14 separately. The separate processing of plural frequency bands of the incoming audio signal 14 by the single integrated circuit 12 is indicated by dashed boxes 16 within the single integrated circuit 12. The dashed boxes 16 may be for example individual amplifiers or amplifier circuits 16 within the single integrated circuit 12. Each amplifier 16 operates on a separate frequency band or bands. The frequency bands may or may not overlap between the various amplifiers 16. Three amplifiers 16 are shown by way of example, but there may be just two amplifiers 16 or more, typically depending on the processing capacity of the integrated circuit 12. The electronic circuit 10 has one or more temperature sensors 18. The temperature sensor(s) 18 may provide a measure of the temperature of the electronic circuit 10 as a whole or of one or more specific components of the electronic circuit 10. The electronic circuit 10 in this example provides an amplified audio signal to one or more loudspeakers 20 for playback to a user.

Referring to Figure 2, another example of an electronic circuit 40 for processing an audio signal has plural integrated circuits 42. The integrated circuits 42 are arranged to process plural frequency bands of an incoming audio signal 44 separately. The plural integrated circuits 42 may be for example individual amplifiers 42, each of which operates on a separate frequency band or bands and which may be for example individual amplifier circuits or amplifier chips. The frequency bands may or may not overlap between the various amplifiers 42. Four amplifiers 42 are shown by way of example, but there may be just two amplifiers 42 or more. The amplifiers 42 may be provided on a single circuit board 46. The electronic circuit 40 has one or more temperature sensors 48. The temperature sensor(s) 48 may provide a measure of the temperature of the electronic circuit 40 as a whole or of one or more specific components of the electronic circuit 40, such as the individual amplifiers 40. The electronic circuit 40 in this example provides an amplified audio signal to one or more loudspeakers 50 for playback to a user.

The audio signal 14, 44 that is processed may be in analogue form when processed or may be in the form of digital audio data when processed. In general, where amplifiers are used, these may be pre-amplifiers and/or power amplifiers and/or single "integrated" amplifiers.

One of the most significant contributors to excess heat being generated in such electronic circuits 10, 40 is heat that is generated by an amplifier when a high gain is being applied by the amplifier to the audio signal 14, 44 in order to amplify the audio signal 14, 44. In order to prevent excessive heat damaging one or more components of the electronic circuit 10, 40, including in particular the amplifiers 16, 42 of the examples discussed above, the example electronic circuits 10, 40 are configured to operate as follows.

If the one or more temperature sensors 18, 48 detects that the temperature of the circuit 10, 40 exceeds a predetermined threshold temperature, which is predefined previously according to for example the function and operation of the electronic circuit 10, 40, then the circuit 10, 40 may be operated so as to reduce the gain of at least one of the amplifiers 16, 42. (This may for example be under control of some overall system controller, not shown.) The effect of this is that only the volume of the frequency band amplified by that particular amplifier 16, 42 is reduced. The volume(s) of the other frequency band(s) may be left unaltered. This can mean that the reduction of the gain of the particular amplifier 16, 42 may be practically unnoticeable to the user. The temperature that is used for this purpose may be the temperature of the circuit 10, 40 as a whole and/or may be the temperature of individual parts or components of the circuit 10, 40, including for example the individual amplifiers 16,42; references to the temperature of the circuit 10,40 shall be construed accordingly unless the context requires otherwise. The threshold temperature may be different for individual parts or components of the circuit 10, 40, including for example the individual amplifiers 16,42.

The frequency band whose volume is reduced may be for example at the low (bass) end of the audio spectrum (say below 200Hz or below 100Hz for example). The frequency band whose volume is reduced may alternatively be for example at the high (treble) end of the audio spectrum (say above 5kHz or above 10kHz for example).

Where there are three or more amplifiers 16, 42, the circuit 10, 40 may be operated so as to reduce the gain of at least two of the amplifiers 16, 42. One of those amplifiers 16, 42 may be operating on a frequency band at the low (bass) end of the audio spectrum (say below 200Hz or below 100Hz for example) and the other of the amplifiers 16, 42 may be operating on a frequency band at the high (treble) end of the audio spectrum (say above 5kHz or above 10kHz for example). In this way, the middle range of the audio frequencies may be left unaltered, again helping to ensure that the reduction of gain is practically unnoticeable to the user.

Moreover, the perception of volume of a user is often such that a reduction of volume in one part of the audio spectrum can be perceived by a user as leading to an increase in volume in the other parts of the audio spectrum. Accordingly, in another example, the circuit 10, 40 may be operated so as to reduce the gain of at least two of the amplifiers 16, 42. One of those amplifiers 16, 42 may be operating on a frequency band at the low (bass) end of the audio spectrum (say below 200Hz or below 100Hz for example) or at the high (treble) end of the audio spectrum (say above 5kHz or above 10kHz for example). The other of the amplifiers 16, 42 may be operating on a frequency band that is in the middle of the range of human hearing, say a frequency band (somewhere) in the range 200Hz to 5kHz. The first amplifier may be operated to make a relatively large reduction in the gain that is applied at the bass or treble end respectively, and the other amplifier may be operated to make a relatively small reduction in the gain that is applied at the middle of the range. There may be an amplifier for the bass end and an amplifier for the treble end, each of which is operated to make a relatively large reduction in the gain that is applied at the bass and treble end respectively, and there may be an amplifier for the middle of the range which is operated to make a relatively small reduction in the gain that is applied at the middle of the range. Other permutations are possible.

The gain that is applied by the amplifiers 16, 42 may therefore be reduced by different amounts, such as different percentages or proportions of the current gain being applied by the amplifiers 16, 42, for the various different amplifiers 16, 42.

In addition, once a threshold temperature has been exceeded, the circuit 10, 40 may be operated so as to reduce the gain of one or more of the amplifiers 16,42 by a first amount. Then, if the temperature of the circuit 10, 40 has dropped below the threshold, within say a predetermined period of time, no further reduction of gain is required; indeed, the gain of one or more of the amplifiers 16, 42 may be raised again in such a case, possibly back to the original level of gain or some other amount that is less than the original level of gain.

Otherwise, if the temperature of the circuit 10, 40 has not dropped below the threshold, within for example a predetermined period of time, then a further reduction in gain may be applied to one or more of the amplifiers 16, 42. This further reduction may be for example less than the first reduction of gain (for example, as a proportion or percentage of the original gain). As a specific example to illustrate this, the reduction of gain that is first applied may be say 20% of the original gain (of the amplifier concerned) and the second reduction of gain that is applied if necessary may be say 30% of the original gain (of the amplifier concerned), producing a further reduction of 10 percentage points.

Alternatively or additionally, in the case that the temperature of the circuit 10, 40 has not dropped below the threshold, within say a predetermined period of time, then one or more amplifiers 16, 42 for further frequency bands may have their gains reduced to try to bring down the temperature of the circuit 10, 40.

In general, the reduction of gain should be applied so as to minimise the perceptibility of the change for the user. So, initially, if a stepwise reduction is applied over time, a relatively large reduction may be applied to a particular amplifier (so as to try to get the temperature down quickly), and subsequently smaller reductions of gain are applied if necessary. Similarly, when restoring the gain, the amount of gain may be increased stepwise in relatively small amounts, again to reduce the perceptibility of the changes for the user. For example to illustrate this, when restoring the gain, the amount of gain applied by a particular amplifier may be increased from a reduction of the original gain of 30% in steps of say 20% reduction and 10% reduction to 0% of the gain that was initially being applied.

As another example, the reduction in gain that is applied for one or more frequency bands may be in terms of the overall power output by the amplifiers 16,42. For example, the gain of one or more of the amplifiers 16, 42 may be reduced so as to achieve a first percentage drop in the overall power output by the amplifiers 16, 42. If that is not sufficient to achieve a desired temperature drop, then one or more amplifiers 16,42 for other frequency bands may be selected so as to have their gains reduced, and/or the gain of the first selected one or more of the amplifiers 16, 42 may be reduced further to achieve a second percentage drop in the overall power output by the amplifiers 16,42. To illustrate this, the first percentage drop may be for example 30% of the overall (original) power output by the amplifiers 16, 42 and if that is not sufficient to bring the temperature below the threshold, then the gain of first amplifiers may be further reduced and/or the gain applied by other(s) of the transistors may be reduced so that the second percentage drop may be for example 50% of the overall (original) power output by the amplifiers 16, 42. This may be repeated as necessary, with further reductions in gain of the same or other amplifiers 16,42. Once the temperature has dropped below the threshold, the gain of one or more of the amplifiers 16, 42 may be raised again. Similar to the above, the amount of gain may be increased stepwise in relatively small amounts, again to reduce the perceptibility of the changes for the user. For example to illustrate this, when restoring the gain, the amount of gain applied by a particular amplifier may be increased from a reduction of the original gain that achieved say a 30% drop of the overall (original) power output by the amplifiers 16,42 in steps of say 10 percentage points, i.e. through 20% reduction and 10% reduction to 0% of the overall (original) power output by the amplifiers 16, 42.

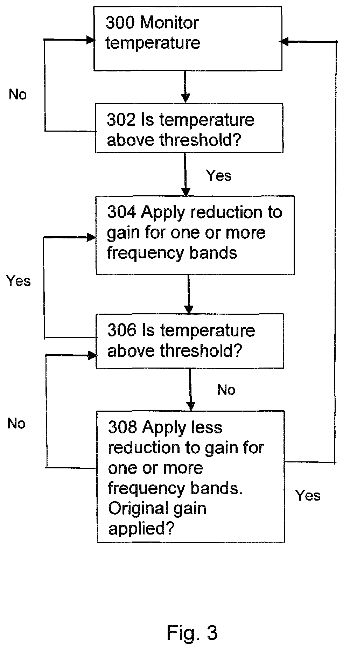

An example of a method is illustrated schematically in the flow chart of Figure 3. At 300, the temperature of the electronic circuit is monitored. At 302, the temperature is compared to a threshold. If the monitored temperature does not exceed the threshold, flow returns to 300 and the temperature continues to be monitored.

If on the other hand the monitored temperature does exceed the threshold, flow passes to 304 where a reduction of gain is applied for one or more frequency bands.

At 306, it is checked again whether the temperature exceeds the threshold following the reduction of gain. If yes, then flow returns to 304 and a further reduction to the gain is applied, either for the same frequency band or for another frequency band. The temperature is then checked against the threshold at 306 and the flow continues as described.

If at 306 the temperature does not exceed the threshold following the reduction of gain, then flow passes to 308 at which less reduction to the gain is applied to one or more frequency bands. If the gain that is applied after the reduction has returned to the original gain, then flow passes back to 300 and the flow continues as described. Otherwise, if at 308 the gain that is applied after the reduction has not returned to the original gain, then flow passes back to 306 and the flow continues as described.

The effect of this is that a gain that is applied is first reduced. If that is sufficient to lower the temperature of the circuit, then the flow in effect determines whether the gain can be raised again. Otherwise, if the reduction in gain does not achieve a sufficient lowering of temperature, then a further reduction of gain can be applied.

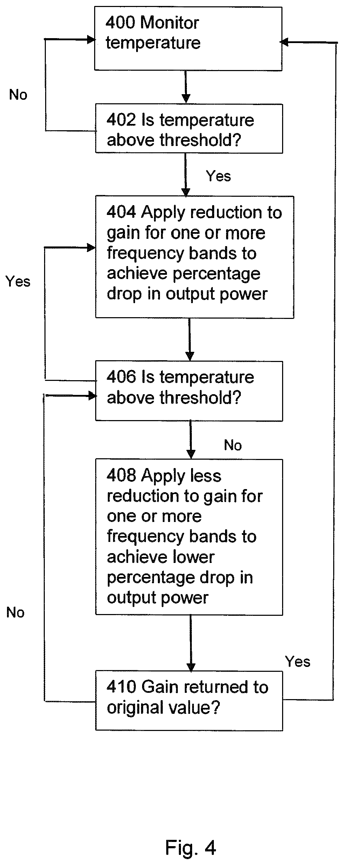

Another example of a method is illustrated schematically in the flow chart of Figure 4.

At 400, the temperature of the electronic circuit is monitored. At 402, the temperature is compared to a threshold. If the monitored temperature does not exceed the threshold, flow returns to 400 and the temperature continues to be monitored.

If on the other hand the monitored temperature does exceed the threshold, flow passes to 404 where a reduction of gain is applied for one or more frequency bands so as to achieve a (first) percentage drop in the total power that is output by the circuit/amplifiers.

At 406, it is checked again whether the temperature exceeds the threshold following the reduction of gain. If yes, then flow returns to 404 and a further reduction to the gain is applied, either for the same frequency band or for another frequency band, so as to achieve a second percentage drop in the total power that is output by the circuit/amplifiers. The temperature is then checked against the threshold at 406.

If at 406 the temperature does not exceed the threshold following the reduction of gain, then flow passes to 408 at which less reduction to the gain is applied to one or more frequency bands to achieve lower percentage drop in output power . It is checked at 410 if the gain that is applied after the reduction has returned to the original gain. If yes, then flow passes back to 400 and the flow continues as described. Otherwise, if at 410 the gain that is applied after the reduction has not returned to the original gain, then flow passes back to 406 and the flow continues as described.

The effect of this again is that a gain that is applied is first reduced. If that is sufficient to lower the temperature of the circuit, then the flow in effect determines whether the gain can be raised again. Otherwise, if the reduction in gain does not achieve a sufficient lowering of temperature, then a further reduction of gain can be applied. In each case, the gain that is applied is determined as a percentage or proportion of the total output power of the circuit/amplifiers.

It will be understood that in general the processor or processing system or circuitry referred to herein may in practice be provided by a single chip or integrated circuit or plural chips or integrated circuits, optionally provided as a chipset, an application-specific integrated circuit (ASIC), field-programmable gate array (FPGA), digital signal processor (DSP), graphics processing units (GPUs), etc. The chip or chips may comprise circuitry (as well as possibly firmware) for embodying at least one or more of a data processor or processors and a digital signal processor or processors, which are configurable so as to operate in accordance with the exemplary embodiments. In this regard, the exemplary embodiments may be implemented at least in part by computer software stored in (non-transitory) memory and executable by the processor, or by hardware, or by a combination of tangibly stored software and hardware (and tangibly stored firmware).

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. An electronic circuit, the electronic circuit comprising:
circuitry for separately processing plural frequency bands of an audio signal;
a temperature monitor for monitoring the temperature of the electronic circuit; and
a controller arranged to adjust the processing of at least one of the plural frequency bands of the audio signal so as to reduce the temperature of the electronic circuit if the temperature of the electronic circuit exceeds a predetermined threshold.

2. An electronic circuit according to claim 1, wherein the controller is arranged such that the adjusting comprises adjusting the processing of some but not all of the plural frequency bands of the audio signal so as to reduce the temperature of the electronic circuit.

3. An electronic circuit according to claim 1 or claim 2, wherein the electronic circuit comprises an integrated circuit.

4. An electronic circuit according to claim 1 or claim 2, wherein the electronic circuit comprises plural integrated circuits.

5. An electronic circuit according to claim 3 or claim 4, wherein the or each integrated circuit is an amplifier and the processing comprises amplifying the audio plural frequency bands of the audio signal, arranged such that the adjusting the processing of said at least one of the plural frequency bands of the audio signal comprises reducing the gain applied to said at least one of the plural frequency bands of the audio signal.

6. An electronic circuit according to claim 5, arranged such that if the temperature of the electronic circuit still exceeds a predetermined threshold after the gain applied to said at least one of the plural frequency bands of the audio signal is reduced, then the controller at least one of (i) further reduces the gain applied to said at least one of the plural frequency bands and (ii) reduces the gain applied to at least one other of the plural frequency bands.

7. An electronic circuit according to claim 1, wherein the electronic circuit comprises plural amplifiers, each amplifier being arranged to amplify a respective frequency band, and the controller is arranged to reduce the gain applied by the amplifiers to the respective plural frequency bands of the audio signal by different amounts.

8. A method of operating an electronic circuit, the electronic circuit being configured to process an audio signal in which the audio signal is divided into plural frequency bands and the electronic circuit is configured to process the plural frequency bands separately, the method comprising:
the electronic circuit processing plural frequency bands of an audio signal;
monitoring the temperature of the electronic circuit; and
if the temperature of the electronic circuit exceeds a predetermined threshold, adjusting the processing of at least one of the plural frequency bands of the audio signal so as to reduce the temperature of the electronic circuit.

9. A method according to claim 8, wherein the adjusting comprises adjusting the processing of some but not all of the plural frequency bands of the audio signal so as to reduce the temperature of the electronic circuit.

10. A method according to claim 8 or claim 9, wherein the electronic circuit comprises an integrated circuit.

11. A method according to claim 8 or claim 9, wherein the electronic circuit comprises plural integrated circuits.

12. A method according to claim 10 or claim 11, wherein the or each integrated circuit is an amplifier and the processing comprises amplifying the audio plural frequency bands of the audio signal, wherein the adjusting the processing of said at least one of the plural frequency bands of the audio signal comprises reducing the gain applied to said at least one of the plural frequency bands of the audio signal.

13. A method according to claim 12, wherein if the temperature of the electronic circuit still exceeds a predetermined threshold after the gain applied to said at least one of the plural frequency bands of the audio signal is reduced, then the method comprises at least one of (i) further reducing the gain applied to said at least one of the plural frequency bands and (ii) reducing the gain applied to at least one other of the plural frequency bands.

14. A method according to claim 8, wherein the electronic circuit comprises plural amplifiers, each amplifier being arranged to amplify a respective frequency band, and the adjusting the processing comprises reducing the gain applied by the amplifiers to the respective plural frequency bands of the audio signal by different amounts.
